# FASCICULE DE BREVET EUROPEEN

(11) **EP 2 412 019 B1**
(45) Date de publication et mention de la délivrance du brevet: **26.02.2014**
(21) Numéro de dépôt: 10709853.5
(22) Date de dépôt: 24.03.2010
(51) Int. Cl.: H01L 21/768, H01L 21/288, B82Y 10/00, B82Y 30/00

(54) **PROCÉDÉ DE RÉALISATION D'INTERCONNEXIONS ÉLECTRIQUES A NANOTUBES DE CARBONE**
VERFAHREN ZUM HERSTELLEN VON AUS KOHLENSTOFFNANORÖHREN BESTEHENDEN ELEKTRISCHEN VERBINDUNGEN
METHOD FOR PRODUCING ELECTRICAL INTERCONNECTIONS MADE OF CARBON NANOTUBES

(30) Priorité: 27.03.2009 FR 0901464
(43) Date de publication de la demande: 01.02.2012
(73) Titulaire: Commissariat à l'Énergie Atomique et aux Énergies Alternatives, 75015 Paris (FR); Centre National de la Recherche Scientifique, 75016 Paris (FR)
(72) Inventeur: HAUMESSER, Paul-Henri, F-38500 Saint Cassien (FR); BASSET, Jean-Marie, F-69300 Caluire-et-Cuire (FR); CAMPBELL, Paul, Middlesbrough T58 OUP (GB); DELEONIBUS, Simon, F-38640 Claix (FR); GUTEL, Thibaut, F-45120 Cepoy (FR); MARCHAND, Gilles, F-38119 Pierre-Chatel (FR); SANTINI, Catherine, F-69660 Collonges Au Mont D'or (FR)
(74) Mandataire: Ilgart, Jean-Christophe
(86) Numéro de dépôt international: PCT/EP2010/053839
(87) Numéro de publication internationale: WO 2010/108957

(56) Documents cités:
- EP-A- 1 946 833
- US-A1- 2006 086 958
- US-A1- 2008 299 307
- LI Z ET AL: "Ionic liquids for synthesis of inorganic nanomaterials" CURRENT OPINION IN SOLID STATE AND MATERIALS SCIENCE, ELSEVIER SCIENCE LTD, OXFORD, GB, vol. 12, no. 1, 1 février 2009 (2009-02-01), pages 1-8, XP025973047 ISSN: 1359-0286 [extrait le 2009-01-29]

## Description

### DOMAINE TECHNIQUE

L'invention concerne la réalisation d'interconnexions électriques dans le domaine de la microélectronique et de la nanoélectronique. L'invention s'applique particulièrement à la réalisation d'interconnexions électriques (lignes de conduction et/ou trous d'interconnexions, ou vias) pour des composants microélectroniques et/ou nanoélectroniques.

### ÉTAT DE LA TECHNIQUE ANTÉRIEURE

Dans le domaine de la microélectronique, les structures d'interconnexions des composants microélectroniques comportent deux types d'éléments :
- les lignes de conduction, qui forment l'essentiel de la circuiterie. Ces lignes sont généralement réalisées sous la forme de plusieurs niveaux ou étages, par exemple au nombre de 10, superposés les uns au-dessus des autres et reliant électriquement différents éléments entre eux, par exemple plusieurs contacts électriques de différents composants,
- les vias, ou trous d'interconnexions, permettant de relier électriquement deux niveaux de lignes de conduction entre eux.

Les structures d'interconnexions sont généralement réalisées à partir de cuivre du fait de sa faible résistance électrique et de sa bonne résistance à l'électromigration, c'est-à-dire aux mouvements de matière sous l'influence de flux d'électrons.

Toutefois, la miniaturisation des dispositifs microélectroniques entraîne une réduction de la taille des structures d'interconnexions. A courant constant, la réduction des sections des interconnexions implique une augmentation des densités de courants dans ces interconnexions. Ainsi, les générations de dispositifs dont les largeurs de lignes sont inférieures à environ 50 nm, par exemple les composants électroniques réalisés en technologie 22 nm, nécessiteront des densités de courants supérieures à 2.10⁶ A/cm², augmentant le phénomène d'électromigration au-delà des limites supportables pour des interconnexions à base de cuivre. Par ailleurs, la résistivité du cuivre augmente à mesure que la section des interconnexions diminue, rendant l'utilisation du cuivre incompatible pour des structures de dimensions inférieures à environ 50 nm.

Afin de pallier ces problèmes, il est envisagé de remplacer les structures d'interconnexions à base de cuivre par des structures d'interconnexions à base de nanotubes de carbone, à la fois pour les vias (trous de contacts ou d'interconnexions) et les lignes de conduction. Les nanotubes de carbone sont dans ce cas réalisés par PECVD (dépôt chimique en phase vapeur assisté par plasma) car il s'agit de la seule technique de synthèse de nanotubes connue à ce jour dont la température de mise en oeuvre soit suffisamment faible pour être compatible avec les architectures utilisées en microélectronique.

Cependant, cette technique nécessite de réaliser un dépôt préalable d'un catalyseur, sous la forme de nanoparticules à base d'un matériau électriquement conducteur, permettant de réaliser ensuite la croissance des nanotubes de carbone à partir de ce catalyseur. La densité et la taille des nanotubes de carbone obtenus dépendent de la densité surfacique et de la taille des nanoparticules métalliques formant le catalyseur. Pour la réalisation de telles structures d'interconnexions, la densité des nanotubes de carbone doit être suffisante pour former un réseau de nanotubes de carbone suffisamment conducteur. Cela implique d'avoir une densité minimale de sites catalytiques, c'est-à-dire de nanoparticules, de l'ordre de 10¹² à 10¹³ nanoparticules/cm². De plus, il existe également des contraintes concernant le diamètre des nanotubes de carbone, celui-ci ne devant pas dépasser environ 10 nm.

Ce dépôt de nanoparticules peut par exemple être réalisé en couche mince. Dans ce cas, un film épais de quelques nanomètres et à base d'un matériau électriquement conducteur est déposé sur la surface destinée à recevoir les nanotubes de carbone. En soumettant cette couche mince à un chauffage, celle-ci se fracture et coalesce en nanoparticules pouvant servir alors de catalyseurs à la croissance des nanotubes de carbone. Ce dépôt de sites catalyseurs peut également être obtenu en utilisant des nanoparticules métalliques colloïdales dispersées dans un solvant organique et stabilisées par un surfactant, puis appliquées sur la surface souhaitée par un dépôt par centrifugation (« spin coating » en anglais).

EP1946833A1 décrit un procédé de réalisation d'interconnexions électriques de nanotubes de carbone comprenant le dépôt d'un catalyseur en utilisant des nanoparticules dispersées dans un solvant.

Toutefois, quelle que soit la technique utilisée pour former le dépôt de nanoparticules, il est difficile d'obtenir une densité de nanoparticules satisfaisante, permettant de réaliser ensuite une croissance de nanotubes de carbone à partir de ces nanoparticules pour former des interconnexions. De plus, la taille des nanoparticules, ainsi que leur dispersion et leur distribution sont difficilement contrôlables, ce qui pose de gros problèmes pour la réalisation d'interconnexions à nanotubes de carbone à partir de ces dépôts de nanoparticules car ces paramètres influent directement sur la taille, la densité et la dispersion des nanotubes de carbone obtenus.

### EXPOSÉ DE L'INVENTION

Un but de la présente invention est de proposer un procédé de réalisation d'interconnexions électriques à base de nanotubes de carbone ne présentant pas les inconvénients de l'art antérieur, c'est-à-dire permettant d'améliorer le contrôle de la taille, de la densité et de la dispersion des nanotubes de carbone réalisés.

Pour cela, la présente invention propose un procédé de réalisation d'interconnexions électriques de nanotubes de carbone, comportant au moins les étapes de :
a) dépôt d'un liquide ionique comprenant des nanoparticules d'au moins un matériau électriquement conducteur en suspension, recouvrant au moins une surface d'un élément destiné à servir de support aux nanotubes de carbone,
b) formation d'un dépôt desdites nanoparticules au moins contre ladite surface de l'élément,
c) retrait du liquide ionique restant,
d) croissance des nanotubes de carbone à partir desdites nanoparticules déposées, et comportant en outre, entre l'étape c) de retrait du liquide ionique (116) restant et l'étape d) de croissance de nanotubes de carbone (126), une étape de passivation des nanoparticules (124) déposées ne se trouvant pas contre ladite surface de l'élément (110).

On entend par liquide ionique un sel organique ou un mélange de sels organiques dont le point de fusion est inférieur ou égal à environ 100 °C, formant des associations de cations organiques et d'anions organiques ou inorganiques.

L'utilisation d'un liquide ionique dans le procédé selon l'invention pour la réalisation et le dépôt de nanoparticules utilisées en tant que catalyseurs présente plusieurs avantages.

Tout d'abord, un liquide ionique possède une faible volatilité et une tension de vapeur très faible contrairement aux solvants organiques volatils ou aux solvants aqueux. Les liquides ioniques sont donc utilisables à des températures beaucoup plus élevées et des pressions beaucoup plus faibles que les solvants organiques volatils. De plus, les liquides ioniques présentent également une grande stabilité thermique jusqu'à des températures par exemple supérieures à environ 400°C, et une grande stabilité chimique, ce qui est un avantage d'un point de vue sécurité de mise en oeuvre de procédés industriels par rapport aux solvants organiques.

Les liquides ioniques permettent également un recyclage et une purification des produits réactionnels aisés. Ils sont également non inflammables et présentent un fort pouvoir de solubilisation aussi bien des sels que des molécules organiques neutres, des polymères, de divers matériaux comme les complexes de métaux de transition (par exemple des catalyseurs), ou encore des gaz.

Les liquides ioniques sont utilisables en électrochimie du fait de leur conductivité ionique et de leur large fenêtre électrochimique, et leurs propriétés physiques sont modulables en fonction du type d'anion et de cation qui le composent. Leur large fenêtre électrochimique permet également la synthèse d'un large éventail de métaux, en particulier ceux non accessibles par exemple en électrochimie en milieu aqueux, tels que le fer pouvant être utilisé pour la croissance de nanotubes de carbone.

Les liquides ioniques présentent également une faible tension de surface, permettant un bon mouillage des surfaces à traiter. Cette propriété assure une bonne pénétration du liquide à l'intérieur des motifs (flancs de lignes ou fond de vias), contrairement aux procédés de l'art antérieur de type "démouillage" dans lesquels les films minces initiaux sont déposés par PVD, technique de dépôt non conforme.

De plus, l'invention permet d'avoir un très bon contrôle de la taille nominale des nanoparticules, ainsi qu'une distribution homogène des tailles de ces nanoparticules, dans le liquide ionique, permettant ainsi de moduler aisément la taille des nanotubes de carbone réalisés à partir des nanoparticules déposées et d'assurer une homogénéité structurale accrue des nanotubes, ce qui garantit de meilleures performances de conduction des interconnexions par rapport aux interconnexions réalisées selon les procédés de l'art antérieur.

Le procédé selon l'invention permet d'obtenir un dépôt de nanoparticules mono-disperses, c'est-à-dire comportant toutes une taille sensiblement similaire à un ou deux atomes près (une nanoparticule pouvant comporter par exemple environ une centaine d'atomes). Les nanoparticules déposées ne se touchent pas entre elles.

L'utilisation d'un liquide ionique offre en outre des propriétés de mouillage qui sont favorables à la pénétration de celui-ci dans des structures gravées submicroniques, ainsi que de très bonnes propriétés rhéologiques favorisant le contrôle de l'étalement du liquide ionique, par exemple lors d'un dépôt de celui-ci par centrifugation (« spin coating » en anglais) ou par projection (« spraying » en anglais).

Le liquide ionique peut être déposé lors de l'étape a) par centrifugation, projection ou par immersion.

L'étape b) de formation du dépôt desdites nanoparticules peut comporter au moins une étape d'incubation dudit élément et du liquide ionique pendant une durée comprise entre environ une minute et une heure, ou supérieure ou égale à environ une minute.

Une différence de potentiel électrique non nulle peut être appliquée entre ledit élément et le liquide ionique au cours d'au moins une partie de l'étape b) de formation du dépôt de nanoparticules. Dans ce cas, le liquide ionique est déposé de préférence par immersion

L'étape c) de retrait du liquide ionique peut comporter une étape de rinçage par un solvant et une étape de séchage, ou une étape de dégradation du liquide ionique par un traitement thermique à une température par exemple comprise entre environ 200°C et 450°C, ou entre environ 200°C et 400°C. La réalisation d'un traitement thermique pour éliminer l'excès de liquide ionique permet notamment de maximiser la densité des nanoparticules déposées. Dans le cas d'une élimination du liquide ionique restant par une dégradation par traitement thermique, cette dégradation peut être assistée par une source d'énergie, par exemple une source de rayons ultraviolets, éclairant le liquide ionique lors de la dégradation thermique.

De préférence, le liquide ionique peut comporter au moins un cation de type imidazolium porteur de substituants alkyles. Un tel liquide ionique permet notamment d'améliorer la répétitivité concernant le contrôle de la taille des nanoparticules de la couche électriquement conductrice, la taille d'un substituant alkyle correspondant à une taille de nanoparticule donnée.

Le liquide ionique peut être choisi parmi du BMIMNTf₂, du HMIMNTf₂ ou du OMIMNTf₂, et/ou les nanoparticules en suspension dans le liquide ionique peuvent être à base de ruthénium ou tout autre matériau électriquement conducteur adapté à la réalisation d'un catalyseur pour la croissance de nanotubes de carbone.

Le procédé comporte en outre, entre l'étape c) de retrait du liquide ionique restant et l'étape d) de croissance de nanotubes de carbone, une étape de passivation des nanoparticules déposées ne se trouvant pas contre ladite surface de l'élément.

L'étape d) de croissance de nanotubes de carbone à partir desdites nanoparticules peut être réalisée par PECVD.

Le liquide ionique déposé à l'étape a) peut recouvrir au moins deux surfaces en regard l'une de l'autre, le dépôt de nanoparticules pouvant être formé, lors de l'étape b), au moins contre lesdites deux surfaces, et dans lequel les nanotubes de carbone réalisés peuvent joindre des nanoparticules disposées contre lesdites deux surfaces.

Ledit élément peut être une région électriquement conductrice d'un dispositif microélectronique.

Les interconnexions réalisées peuvent former des lignes de conduction et/ou des vias reliés électriquement à au moins un dispositif microélectronique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

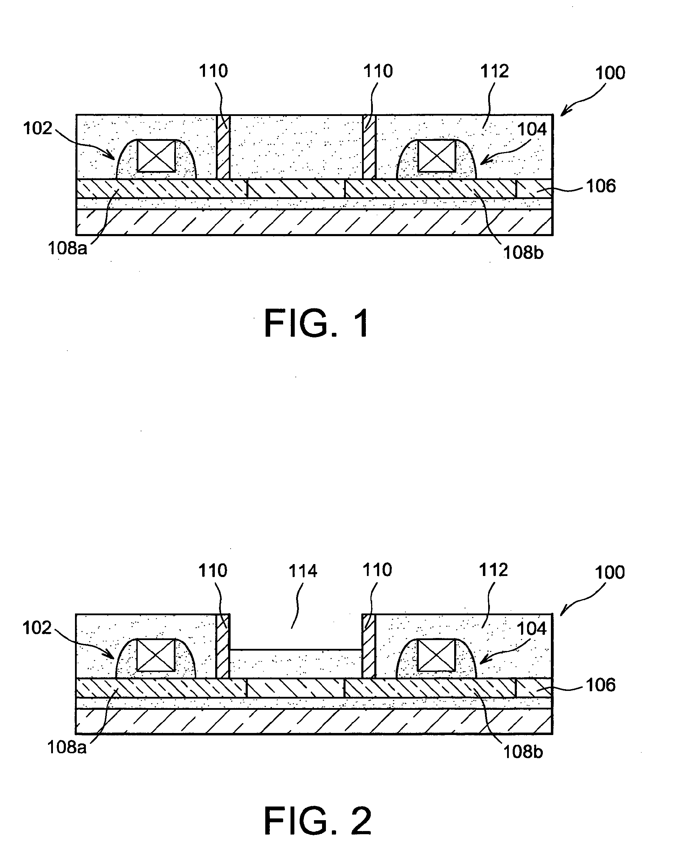

- les figures 1 à 6 représentent les étapes d'un procédé de réalisation d'interconnexions électriques de nanotubes de carbone, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère aux figures 1 à 6 qui représentent des étapes d'un procédé de réalisation d'interconnexions électriques de nanotubes de carbone selon un mode de réalisation particulier.

Comme représenté sur la figure 1, les interconnexions sont réalisées dans un dispositif microélectronique 100 comportant deux transistors MOS 102 et 104. Ces deux transistors MOS 102, 104 comportent chacun une zone active 108a et 108b, dans laquelle sont formées des régions de source, de drain et de canal dans une couche active 106, par exemple à base de semi-conducteur tel que du silicium, d'un substrat SOI (semi-conducteur sur isolant). Les régions de drain de la zone active 108a et de source de la zone active 108b sont reliées électriquement à des vias 110 formés à travers une couche diélectrique 112, par exemple à base d'un oxyde de semi-conducteur ou de nitrure de semi-conducteur, recouvrant l'ensemble des éléments du dispositif 100.

Comme représenté sur la figure 2, un creux 114 est réalisé dans la couche diélectrique 112 entre les deux vias 110, formant un emplacement des interconnexions qui vont être réalisées entre les vias 110 et les relier électriquement entre eux.

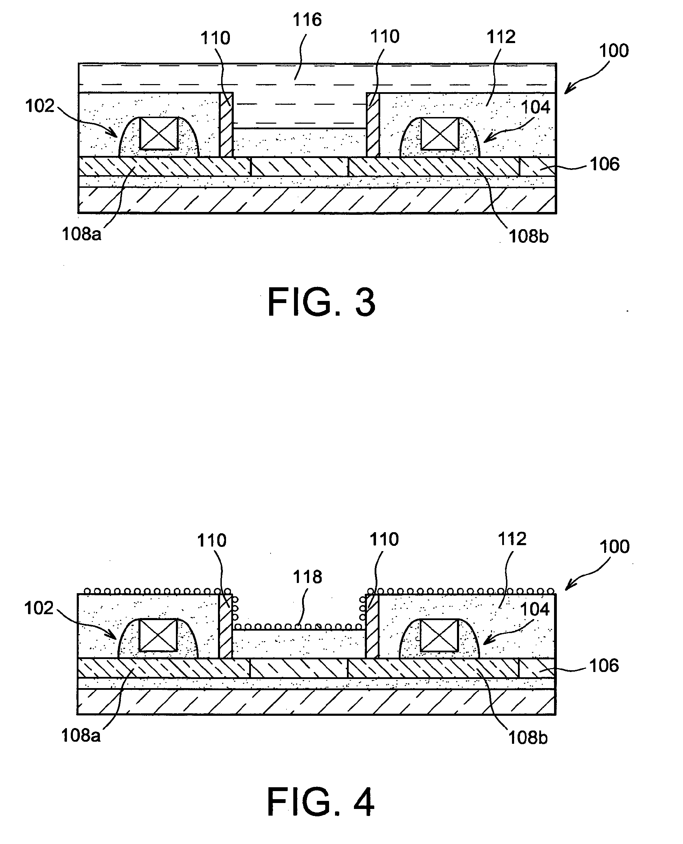

On étale ensuite sur l'ensemble de la structure précédemment réalisée, par exemple par la mise en oeuvre d'un dépôt par centrifugation, par pulvérisation ou par immersion, un liquide ionique 116 dans lequel des nanoparticules métalliques ont été synthétisées. Le liquide ionique 116 recouvre alors la couche diélectrique 112, les parois des vias 110 et remplit le creux 114 (figure 3).

Les nanoparticules sont des agrégats de quelques dizaines d'atomes ou d'une centaine d'atomes de métaux de transition (ruthénium, rhodium, palladium, etc, ...) présentant des géométries variables et dont les dimensions sont de l'ordre de quelques nanomètres, par exemple présentant un diamètre compris entre environ 1 nm et 10 nm. La présence d'un nombre important d'atomes en surface conduit à des propriétés magnétiques, électroniques et catalytiques à la frontière entre l'état moléculaire et l'état massique.

La synthèse des nanoparticules dans un liquide ionique peut être réalisée en mettant en solution un complexe organométallique dans un liquide ionique matrice sous agitation à température ambiante puis à refroidir le milieu réactionnel à une température proche de 0°C. Le milieu est pressurisé sous hydrogène pendant un temps compris entre quelques heures et quelques jours (en fonction des complexes) jusqu'à l'obtention d'une suspension de nanoparticules métalliques.

Par liquide ionique matrice, on entend un liquide ionique à température ambiante capable de solubiliser une ou plusieurs espèces chimiques telles que les sels minéraux ou organiques, ou les molécules organiques ou organométalliques. Ce liquide ionique peut être utilisé pur ou être mélangé et composé d'un ou plusieurs liquides ioniques fonctionnalisés (par exemple une amine, un alcool, un thiol ou un éther) ou non. Le liquide ionique peut également être mélangé à un autre solvant hydrophobe.

On décrit ci-dessous trois exemples de réalisation de synthèses de nanoparticules métalliques dans des liquides ioniques, les liquides ioniques obtenus, qui comportent des nanoparticules métalliques en suspension, pouvant être utilisés dans le procédé de réalisation d'interconnexions décrit ici.

### Exemple de synthèse de nanoparticules de ruthénium dans un liquide ionique du type BMIMNTf₂ :

Dans une boîte à gants, c'est-à-dire une boîte hermétique sous atmosphère contrôlée (par exemple sous atmosphère d'argon) dans laquelle les manipulations sont réalisées avec des gants, on introduit, dans un autoclave en verre, 10 ml de bis(trifluoromethanesulfonyl)imide 1-butyl-3-methyl imidazolium (BMIMNTf₂). On y dissout ensuite totalement, à température ambiante et sous forte agitation pendant 1 heure, du Ru(COD)(COT) (135 mg, 0,43 mmol, C=0,043 mol/L). Lorsqu'une solution homogène est obtenue, le milieu réactionnel est refroidi à une température égale à environ 0°C et l'agitation est arrêtée. La température du milieu est stabilisée à environ 0°C. L'autoclave est alors balayé sous courant d'hydrogène puis pressurisé sous hydrogène à 4 bars pendant 72 heures. Le milieu est alors évacué sous vide pour éliminer le cyclooctane (COA) formé. Une suspension colloïdale noire de nanoparticules de ruthénium, dont chacune a un diamètre égale à environ 1,1 nm +/ 0,2 nm, dispersées de façon homogène sans aucune agglomération et dont la distribution des tailles est très étroite, est ainsi obtenue.

La suspension de nanoparticules de ruthénium obtenue dans le liquide ionique est stable plusieurs mois lorsque celle-ci est disposée sous atmosphère d'argon, à température ambiante. De plus, même en réalisant une centrifugation de la solution obtenue ou en réalisant une précipitation par des solvants organiques (alcanes, dichlorométhane, acétonitrile), aucune décantation des nanoparticules de ruthénium n'est observée dans le liquide ionique.

### Exemple de synthèse de nanoparticules de ruthénium dans un liquide ionique du type HMIMNTf₂ :

Dans une boîte à gants, on introduit dans un autoclave en verre 10 ml de bis(trifluoromethanesulfonyl)imide 1-hexyl-3-methyl imidazolium (HMIMNTf₂). On y dissout ensuite totalement, à température ambiante et sous forte agitation pendant 1 heure, du Ru(COD)(COT) (135 mg, 0,43 mmol, C=0,043 mol/L). Lorsqu'une solution homogène est obtenue, le milieu réactionnel est refroidi à une température égale à environ 0°C et l'agitation est arrêtée. La température du milieu est stabilisée à environ 0°C. L'autoclave est alors balayé sous courant d'hydrogène puis pressurisé sous hydrogène à 4 bars pendant 72 heures. Le milieu est alors évacué sous vide pour éliminer le cyclooctane (COA) formé. Une suspension colloïdale noire de nanoparticules de ruthénium, dont chacune a un diamètre égale à environ 1,9 nm +/ 0,2 nm, dispersées de façon homogène sans aucune agglomération et dont la distribution des tailles est très étroite, est ainsi obtenue.

Là encore, la suspension de nanoparticules de ruthénium obtenue dans le liquide ionique est très stable plusieurs mois lorsque celle-ci est disposée sous atmosphère d'argon, à température ambiante. De plus, même en réalisant une centrifugation de la solution obtenue ou en réalisant une précipitation par des solvants organiques (alcanes, dichlorométhane, acétonitrile), aucune décantation des nanoparticules de ruthénium n'est observée dans le liquide ionique.

### Exemple de synthèse de nanoparticules de ruthénium dans un liquide ionique du type OMIMNTf₂ :

Dans une boîte à gants, on introduit dans un autoclave en verre 10 ml de bis(trifluoromethanesulfonyl)imide 1-octyl-3-methyl imidazolium (OMIMNTf₂). On y dissout ensuite totalement, à température ambiante et sous forte agitation pendant 1 heure, du Ru(COD)(COT) (135 mg, 0,43 mmol, C=0,043 mol/L). Lorsqu'une solution homogène est obtenue, le milieu réactionnel est refroidi à une température égale à environ 0°C et l'agitation est arrêtée. La température du milieu est stabilisée à environ 0°C. L'autoclave est alors balayé sous courant d'hydrogène puis pressurisé sous hydrogène à 4 bars pendant 72 heures. Le milieu est alors évacué sous vide pour éliminer le cyclooctane (COA) formé. Une suspension colloïdale noire de nanoparticules de ruthénium, dont chacune a une taille égale à environ 1,9 nm +/ 0,2 nm, dispersées de façon homogène sans aucune agglomération et dont la distribution des tailles est très étroite, est ainsi obtenue.

Là encore, la suspension de nanoparticules de ruthénium obtenue dans le liquide ionique est très stable plusieurs mois lorsque celle-ci est disposée sous atmosphère d'argon, à température ambiante. De plus, même en réalisant une centrifugation de la solution obtenue ou en réalisant une précipitation par des solvants organiques (alcanes, dichlorométhane, acétonitrile), aucune décantation des nanoparticules de ruthénium n'est observée dans le liquide ionique.

Les liquides ioniques, ainsi que leurs procédés de fabrication, décrits dans le document « Room Temperature Ionic Liquids, Solvents for Synthesis and Catalysis » de Thomas Welton, Chem. Rev, 1999, vol. 99, n°8, pages 2071-2084, peuvent également être utilisés pour la mise en oeuvre du procédé de réalisation d'interconnexions décrit ici.

Après avoir étalé sur l'ensemble de la structure le liquide ionique 116 dans lequel des nanoparticules métalliques ont été synthétisées, on laisse incuber l'ensemble, par exemple à température ambiante et pendant une durée comprise entre environ 1 minute et 1 heure, afin de former un dépôt des nanoparticules 118 se trouvant initialement dans le liquide ionique contre les parois du creux 114, et notamment sur les parois latérales du creux 114 formées par les vias 110, ainsi que sur le diélectrique 112. Ces nanoparticules 118 sont par exemple composées d'une centaine d'atomes chacune. Les nanoparticules 118 ont par exemple chacune un diamètre sensiblement égal à environ 2 nm et sont espacées les unes des autres d'une distance sensiblement équivalente à leur diamètre, c'est-à-dire par exemple 2 nm. La densité des nanoparticules 118 obtenue est par exemple égale à environ 5.10¹³ cm⁻².

La durée d'incubation est notamment choisie en fonction de la densité de nanoparticules souhaitée : plus cette durée d'incubation est longue, plus la densité du dépôt de nanoparticules 118 obtenu sera importante.

Dans une variante, il est possible de fonctionnaliser au préalable la surface sur laquelle les nanoparticules 118 sont déposées, notamment au niveau de l'emplacement des interconnexions. Dans le cas présent, les surfaces à fonctionnaliser seraient les parois latérales du creux 114 formées par les vias 110. Une telle fonctionnalisation permet notamment de favoriser le collage des nanoparticules sur ces surfaces. Une telle fonctionnalisation permet d'apporter un groupement terminal sur la surface sur laquelle les nanoparticules sont déposées qui peut interagir avec les particules métalliques, ce qui peut modifier la cinétique de réaction d'adsorption des particules, leur densité surfacique et leur stabilité sur la surface lors d'une étape de rinçage. Cette fonctionnalisation peut être réalisée par exemple par silanisation ou électrogreffage de sels de diazonium. Les groupements terminaux peuvent être par exemple choisis parmi du thiol, du carboxylate, de l'acide carboxylique, de l'amine, de l'ammonium, du thioester, du thiourée, etc.

Une telle fonctionnalisation pourrait également être mise en oeuvre pour rendre complètement inertes les zones diélectriques entourant les zones électriquement conductrices destinées à recevoir le dépôt de nanoparticules, par exemple par silanisation, les zones diélectriques pouvant être à base d'oxyde de silicium.

Comme représenté sur la figure 4, on retire ensuite l'excédent de liquide ionique 116, par exemple par un rinçage à l'éthanol à 95 % suivi d'un séchage à l'argon, afin de ne conserver que la couche métallique 118 de nanoparticules et éliminer les restes de solvants. Il est également possible de retirer l'excès de liquide ionique en réalisant une dégradation par un traitement thermique à une température par exemple comprise entre environ 200°C et 450°C. Cette dégradation des résidus de liquide ionique peut également être réalisée durant les premiers instants du dépôt PECVD des nanotubes de carbone réalisé par la suite. Il est possible que les résidus organiques constituent en eux-mêmes une source de carbone pouvant contribuer à initier la croissance des nanotubes de carbone.

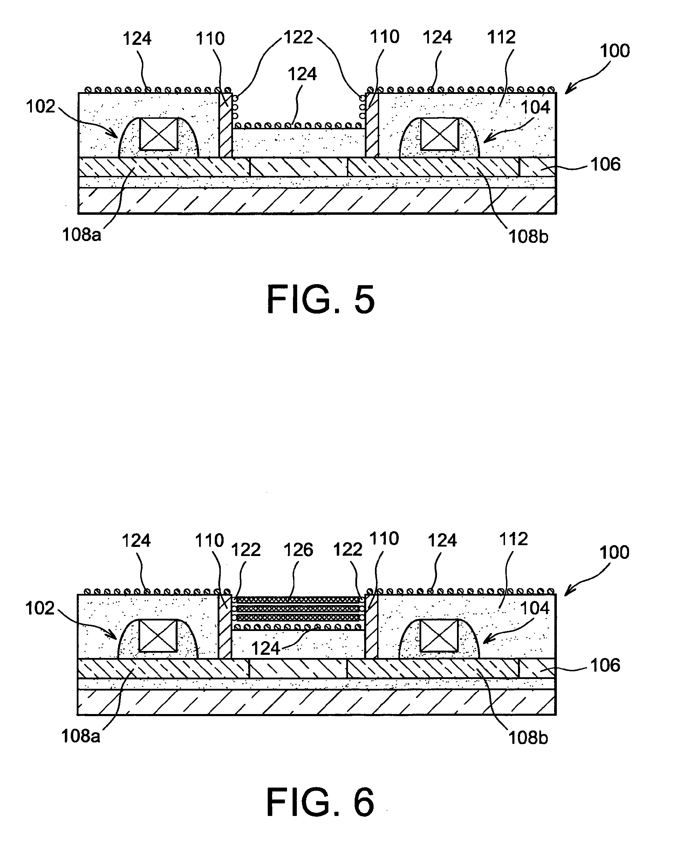

On réalise ensuite une passivation localisée des nanoparticules 118 qui ne sont pas destinées à servir de catalyseurs pour la croissance des nanotubes de carbone, c'est-à-dire ici des nanoparticules 118 se trouvant sur le diélectrique 112 et sur le sommet des vias 110, ainsi que sur la paroi de fond du creux 114. Ces nanoparticules passivées sont désignées sur la figure 5 par la référence 124. Seules les nanoparticules 118 se trouvant contre les parois latérales des vias 110 sont conservées électriquement conductrices (figure 5, référence 122). Cette passivation de nanoparticules est par exemple réalisée par des traitements de masquage ou d'empoisonnement localisés, par exemple par des dépôts directionnels. Par exemple, il peut être envisagé de réaliser un dépôt non conforme par pulvérisation qui viendrait masquer les surfaces horizontales sans affecter les nanoparticules 122 se trouvant contre les parois latérales des vias 110 par effet d'ombrage.

Enfin, comme représenté sur la figure 6, on réalise une croissance de nanotubes de carbone 126 en utilisant les nanoparticules 122 électriquement conductrices préalablement déposées contre les vias 110, par exemple par PECVD. En s'étendant entre les nanoparticules 122, les nanotubes 126 forment une interconnexion électrique entre les vias 110, reliant électriquement le drain du transistor 102 à la source du transistor 104.

Chaque nanoparticule 122 forme donc un site catalyseur pour la croissance d'un nanotube de carbone. Les dimensions des nanotubes de carbone réalisés dépendent de la taille des nanoparticules servant de catalyseurs. Ainsi, il est par exemple possible de réaliser des nanotubes à simple paroi en choisissant de déposer des nanoparticules dont les dimensions sont comprises entre environ 1 nm et 3 nm ou des nanotubes à parois multiples, comportant par exemple entre 2 et 10 parois disposées les unes dans les autres, en choisissant de déposer des nanoparticules dont les dimensions sont comprises entre environ 3 nm et 10 nm.

Dans une variante du procédé détaillé ci-dessus, il est possible, après l'étalement du liquide ionique 116, de polariser les vias 110 vis-à-vis du liquide ionique 116, afin de réaliser un dépôt sélectif des nanoparticules sur les vias 110 par rapport aux autres matériaux en contact avec le liquide ionique 116. En appliquant une différence de potentiels entre les vias 110 et le liquide ionique 116, un champ électrique plus intense est présent au niveau des vias 110 qu'au niveau des autres matériaux en contact avec le liquide ionique 116. Cette différence de champ électrique permet d'augmenter la vitesse de dépôt des nanoparticules sur les parois des vias 110 par rapport à celle au niveau de la paroi de fond du creux 114 formée par une partie de la couche de silicium 106 ainsi qu'au niveau de la couche diélectrique 112, et favorise ainsi le dépôt des nanoparticules contenues dans le liquide ionique 116 sur les parois des vias 110. On réalise ainsi un dépôt quasi sélectif des nanoparticules sur les vias 110, au niveau des zones où se trouvent les portions 122 de la couche électriquement conductrice 118.

Le procédé décrit ci-dessus peut également s'appliquer pour la réalisation des vias entre une ligne de conduction, pouvant également être réalisée à partir de nanotubes de carbone, et un contact électrique du dispositif 100, et/ou entre deux niveaux d'interconnexions, et/ou encore pour la réalisation des lignes de conduction des différents niveaux d'interconnexions.

## Revendications

1. Procédé de réalisation d'interconnexions électriques de nanotubes de carbone (126), comportant au moins les étapes de :
a) dépôt d'un liquide ionique (116) comprenant des nanoparticules d'au moins un matériau électriquement conducteur en suspension, recouvrant au moins une surface d'un élément (110) destiné à servir de support aux nanotubes de carbone,
b) formation d'un dépôt desdites nanoparticules (118, 122, 124) au moins contre ladite surface de l'élément (110),
c) retrait du liquide ionique (116) restant,
d) croissance des nanotubes de carbone (126) à partir desdites nanoparticules (118, 122) déposées,
et comportant en outre, entre l'étape c) de retrait du liquide ionique (116) restant et l'étape d) de croissance de nanotubes de carbone (126), une étape de passivation des nanoparticules (124) déposées ne se trouvant pas contre ladite surface de l'élément (110).

2. Procédé selon la revendication 1, dans lequel le liquide ionique (116) est déposé lors de l'étape a) par centrifugation, projection ou immersion.

3. Procédé selon l'une des revendications précédentes, dans lequel l'étape b) de formation du dépôt desdites nanoparticules (118) comporte au moins une étape d'incubation dudit élément (110) et du liquide ionique (116) pendant une durée comprise entre environ une minute et une heure.

4. Procédé selon la revendication 3, dans lequel une différence de potentiel électrique non nulle est appliquée entre ledit élément (110) et le liquide ionique (116) au cours d'au moins une partie de l'étape b) de formation du dépôt de nanoparticules (118).

5. Procédé selon l'une des revendications précédentes, dans lequel l'étape c) de retrait du liquide ionique (116) comporte une étape de rinçage par un solvant et une étape de séchage, ou une étape de dégradation du liquide ionique (116) par un traitement thermique à une température comprise entre environ 200°C et 400°C.

6. Procédé selon l'une des revendications précédentes, dans lequel le liquide ionique (116) comporte au moins un cation de type imidazolium porteur de substituants alkyles.

7. Procédé selon l'une des revendications précédentes, dans lequel le liquide ionique (116) est choisi parmi du BMIMNTf₂, du HMIMNTf₂ ou du OMIMNTf₂, et/ou les nanoparticules en suspension dans le liquide ionique (116) sont à base de ruthénium.

8. Procédé selon l'une des revendications précédentes, dans lequel l'étape d) de croissance de nanotubes de carbone (126) à partir desdites nanoparticules est réalisée par PECVD.

9. Procédé selon l'une des revendications précédentes, dans lequel le liquide ionique (116) déposé à l'étape a) recouvre au moins deux surfaces en regard l'une de l'autre, le dépôt de nanoparticules (118) étant formé, lors de l'étape b), au moins contre lesdites deux surfaces, et dans lequel les nanotubes de carbone (126) réalisés joignent des nanoparticules (122) disposées contre lesdites deux surfaces.

10. Procédé selon l'une des revendications précédentes, dans lequel ledit élément (110) est une région électriquement conductrice d'un dispositif microélectronique (100).

11. Procédé selon l'une des revendications précédentes, dans lequel les interconnexions (126) réalisées forment des lignes de conduction et/ou des vias reliés électriquement à au moins un dispositif microélectronique (100).

## Patentansprüche

1. Verfahren zur Herstellung von elektrischen Verbindungen aus Kohlenstoff-Nanoröhren (126), umfassend wenigstens die Schritte:
a) Aufbringen einer ionischen Flüssigkeit (116), welche Nanopartikel aus wenigstens einem elektrisch leitenden Material in Suspension umfasst, so dass sie wenigstens eine Oberfläche von einem Element (110) bedeckt, welches dazu bestimmt ist, als Träger für die KohlenstoffNanoröhren zu dienen,
b) Bilden einer Ablagerung der Nanopartikel (118, 122, 124) wenigstens an der Oberfläche von dem Element (110),
c) Entfernen der übrig gebliebenen ionischen Flüssigkeit (116),
d) Wachsen der Kohlenstoff-Nanoröhren (126), ausgehend von den abgelagerten Nanopartikeln (118, 122),
und weiterhin umfassend, zwischen dem Schritt c) des Entfernens der übrig gebliebenen ionischen Flüssigkeit (116) und dem Schritt d) des Wachsens von Kohlenstoff-Nanoröhren (126), einen Schritt der Passivierung der abgelagerten Nanopartikel (124), die sich nicht auf der Oberfläche des Elements (110) befinden.

2. Verfahren nach Anspruch 1, wobei die ionische Flüssigkeit (116) beim Schritt a) durch Zentrifugieren, Aufspritzen oder Eintauchen aufgebracht wird.

3. Verfahren nach einem der vorhergehenden Ansprüche, wobei der Schritt b) der Bildung der Ablagerung der Nanopartikel (118) wenigstens einen Schritt der Inkubation des Elements (110) und der ionischen Flüssigkeit (116) während einer Dauer zwischen ungefähr einer Minute und einer Stunde umfasst.

4. Verfahren nach Anspruch 3, wobei wenigstens während einem Teil von dem Schritt b) der Bildung der Ablagerung von Nanopartikeln (118) eine von Null verschiedene Potenzialdifferenz zwischen dem Element (110) und der ionischen Flüssigkeit (116) angelegt wird.

5. Verfahren nach einem der vorhergehenden Ansprüche, wobei der Schritt c) des Entfernens der ionischen Flüssigkeit (116) einen Schritt des Abspülens mit einem Lösungsmittel und einen Trocknungsschritt umfasst, oder einen Schritt des Abbaus der ionischen Flüssigkeit (116) durch eine Wärmebehandlung bei einer Temperatur zwischen ungefähr 200 °C und 400 °C.

6. Verfahren nach einem der vorhergehenden Ansprüche, wobei die ionische Flüssigkeit (116) wenigstens ein Kation vom Imidazolium-Typ umfasst, welches Alkylsubstituenten trägt.

7. Verfahren nach einem der vorhergehenden Ansprüche, wobei die ionische Flüssigkeit (116) ausgewählt ist aus BMIMNTf₂, HMIMNTf₂, oder OMIMNTf₂, oder/und die Nanopartikel in Suspension in der ionischen Flüssigkeit (116) auf Ruthenium basieren.

8. Verfahren nach einem der vorhergehenden Ansprüche, wobei der Schritt d) des Wachsens von Kohlenstoff-Nanoröhren (126) ausgehend von den Nanopartikeln durch PECVD ausgeführt wird.

9. Verfahren nach einem der vorhergehenden Ansprüche, wobei die im Schritt a) aufgebrachte ionische Flüssigkeit (116) wenigstens zwei gegenüberliegende Oberflächen bedeckt, wobei das Ablagern von Nanopartikeln (118) beim Schritt b) wenigstens an den zwei Oberflächen erfolgt, und wobei die hergestellten Kohlenstoff-Nanoröhren (126) sich an die an den zwei Oberflächen abgelagerten Nanopartikel (122) anschließen.

10. Verfahren nach einem der vorhergehenden Ansprüche, wobei das Element (110) ein elektrisch leitfähiger Bereich von einer mikroelektronischen Einrichtung (100) ist.

11. Verfahren nach einem der vorhergehenden Ansprüche, wobei die hergestellten Verbindungen (126) Leiterbahnen oder/und Durchkontaktierungen bilden, die elektrisch mit wenigstens einer mikroelektronischen Einrichtung (100) verbunden sind.

## Claims

1. Method for making electrical interconnections of carbon nanotubes (126), including at least the steps of:
a) depositing an ionic liquid (116) comprising suspended nanoparticles of at least one electrically conducting material, covering at least one surface of an element (110) intended to be used as a support for carbon nanotubes,
b) forming a deposit of said nanoparticles (118, 122, 124) at least against said surface of the element (110),
c) removing the remaining ionic liquid (116),
d) growing carbon nanotubes (126) from said deposited nanoparticles (118, 122),
and further including between step c) of removing the remaining ionic liquid (116) and step d) of growing carbon nanotubes (126), a step of passivating the deposited nanoparticles (124) which are not arranged against said surface of the element (110).

2. Method according to claim 1, wherein the ionic liquid (116) is deposited during step a) by centrifugation, projection or immersion.

3. Method according to one of previous claims, wherein step b) of forming the deposit of said nanoparticles (118) includes at least one step of incubating said element (110) and the ionic liquid (116) for a period between about 1 minute and 1 hour.

4. Method according to claim 3, wherein a non-zero electric potential difference is applied between said element (110) and the ionic liquid (116) at least during one part of step b) of forming the deposit of nanoparticles (118).

5. Method according to one of previous claims, wherein step c) of removing the ionic liquid (116) includes a step of rinsing with a solvent and a drying step, or a step of degrading the ionic liquid (116) with a heat treatment at a temperature between about 200°C and 400°C.

6. Method according to one of previous claims, wherein the ionic liquid (116) includes at least one cation of the imidazolium type bearing alkyl substituents.

7. Method according to one of previous claims, wherein the ionic liquid (116) is selected from BMIMNTf₂, HMIMNTf₂ or OMIMNTf₂, and/or suspended nanoparticles in the ionic liquid (116) comprise ruthenium.

8. Method according to one of previous claims, wherein the step d) of growing carbon nanotubes (126) from said nanoparticles is carried out by PECVD.

9. Method according to one of previous claims, wherein the ionic liquid (116) deposited during step a) covers at least two surfaces facing each other, the deposit of nanoparticles (118) being made, during step b), at least against said two surfaces, and wherein the carbon nanotubes (126) join nanoparticles (122) arranged against said two surfaces.

10. Method according to one of previous claims, wherein said element (110) is an electrically conducting region of a microelectronic device (100).

11. Method according to one of previous claims, wherein the interconnections (126) form conduction lines and/or vias electrically connected to at least one microelectronic device (100).
